# EUROPÄISCHE PATENTSCHRIFT

(11) **EP 1 463 107 B1**
(45) Veröffentlichungstag und Bekanntmachung des Hinweises auf die Patenterteilung: **02.11.2016**
(21) Anmeldenummer: 04007053.4
(22) Anmeldetag: 24.03.2004
(51) Int. Cl.: H01L 21/687

(54) **Vorrichtung und Verfahren zur Handhabung und zum Transport scheibenartiger Elemente**
Apparatus and method for handling and conveying wafers
Dispositif et procédé de manipulation et de transport de plaquettes

(30) Priorität: 28.03.2003 DE 10314383
(43) Veröffentlichungstag der Anmeldung: 29.09.2004
(73) Patentinhaber: Integrated Dynamics Engineering GmbH, 65479 Raunheim (DE)
(72) Erfinder: Heiland, Peter, 65479 Raunheim (DE); Tillmann, Ralf, Dr., 68309 Mannheim (DE)
(74) Vertreter: Herden, Andreas F.

(56) Entgegenhaltungen:
- FR-A- 2 567 160
- US-A1- 2002 048 506
- US-A1- 2003 026 683
- US-B1- 6 190 103
- US-B1- 6 212 961
- PATENT ABSTRACTS OF JAPAN Bd. 009, Nr. 185 (E-332), 31. Juli 1985 (1985-07-31) -& JP 60 054448 A (TOSHIBA KK), 28. März 1985 (1985-03-28)
- PATENT ABSTRACTS OF JAPAN Bd. 009, Nr. 330 (M-442), 25. Dezember 1985 (1985-12-25) -& JP 60 161825 A (TOSHIBA KK), 23. August 1985 (1985-08-23)
- PATENT ABSTRACTS OF JAPAN Bd. 2000, Nr. 11, 3. Januar 2001 (2001-01-03) -& JP 2000 232145 A (DAINIPPON SCREEN MFG CO LTD), 22. August 2000 (2000-08-22)

## Beschreibung

### 1. TECHNISCHES GEBIET

Die Erfindung betrifft eine Vorrichtung zum Wechseln zumindest eines scheibenartigen Elements nach Ansprüche 1 und 17 und ein Verfahren zum Transportieren von Wafern nach Anspruch 14 und ein Handhabungssystem zur Durchführung des Verfahrens von Anspruch 14 nach Anspruch 15.

### 2. BESCHREIBUNG DES STANDES DER TECHNIK

Vorrichtungen zur Annahme und Übertragung von Wafern sind im Rahmen des Standes der Technik bekannt. Zum Beispiel werden üblicherweise Roboterhandhaber dazu verwendet, Materialien, z. B. Halbleiterwafer, zwischen verschiedenen Stufen eines Waferfertigungsprozesses zu bewegen. In diesem Zusammenhang könnten Roboterhandhaber dazu verwendet werden, den Wafer aus einer Plasmaätzstation in einem Gruppenwerkzeug zu einer Beschichtungsstation oder von einer Fertigungsstation zu einer Teststation oder einem Messwerkzeug zu bewegen, wobei der Wafer auf einem Aufspannkopf positioniert ist. Bei dieser Art eines Handhabungssystems hängt der Durchsatz stark von der Zeit ab, die das Messwerkzeug auf das durch den Roboterhandhaber übergebene Material warten muss.

Ein typisches Transport- und Handhabungsszenario für ein Waferhandhabungssystem sieht wie folgt aus:
a) das Handhabungssystem, typischerweise ein einarmiger Roboterhandhaber, erhält einen neuen Wafer,
b) das Handhabungssystem bewegt und lädt den Wafer in die Übertragungsposition zum Übertragen des Wafers zum Beispiel in das Messwerkzeug,
c) der Wafer wird zur Bearbeitung oder Vermessung in das Werkzeug bewegt; danach kommt dieser Wafer zurück zur Übertragungsposition oder zur Entladeposition, die typischerweise die gleiche ist, wie die Ladeposition,
d) das Handhabungssystem, d. h. der Roboterhandhaber, greift den Wafer und entlädt den Wafer in die nächste Position,

Der Zyklus startet von Schritt a).

Während der Bearbeitung des Wafers in dem Messwerkzeug wartet das Handhabungssystem oder der Roboter, oder es oder er führt andere Aufgaben durch. Aber zur Durchführung anderer Aufgaben muss das Handhabungssystem andere Bewegungen ohne Wafer ausführen. Dies ist jedoch ineffektiv und bildet einen Engpass des Transportsystems, der den Durchsatz begrenzt.

Das Problem könnte gelöst werden, indem ein so genannter Dualarm oder Paddel-Roboter eingesetzt wird, da der Dualarmroboter zwei Wafer zugleich handhaben kann. Solch ein Handhabungssystem weist jedoch eine erhöhte Stellfläche auf, da die Arme den überstrichenen Radius des Roboters erhöhen, was durch den Raum bedingt wird, der horizontal erforderlich ist, um den Wafer an der erwünschten Station zu wechseln.

Dokument FR-A-2 567 160, offenbart ein Verfahren und eine Vorrichtung zum Greifen von Silizium-Wafern, mittels zwei Arme.

In einer Reinraumumgebung ist jedoch zur Waferherstellung benötigter Raum eine Mangelware. Daher würde eine Erhöhung der Stellfläche des Handhabungssystems die Herstellungskosten erheblich erhöhen. Diese Art von Robotern ist zudem komplexer handzuhaben und ihr Kaufpreis ist hoch.

Daher besteht Bedarf für eine Lösung, die einerseits den Durchsatz erhöht und andererseits den Raumbedarf beziehungsweise die zusätzliche, erforderliche Stellfläche minimiert.

Diese und weitere Nachteile haben zu der Aufgabe der vorliegenden Erfindung geführt, eine Vorrichtung als Teil eines Handhabungssystem bereitzustellen, die die Verwendung komplexer Handhabungssysteme mit einer großen Stellfläche vermeidet, aber dennoch den Durchsatz beträchtlich erhöhen kann.

### KURZE DARSTELLUNG DER ERFINDUNG

Die erfindungsgemäße Lösung wird durch Bereitstellung einer Vorrichtung nach Ansprüche 1 und 17 erhalten.

Weitere vorteilhafte Entwicklungen sind Teil der jeweiligen abhängigen Ansprüche.

Die erfindungsgemäße Vorrichtung kann zum Beispiel vorteilhafterweise einfach in einer Linie oder in Reihe mit einem einarmigen Handhabungssystem und einer Ladeposition beispielsweise eines Aufspannkopfs eines Bewegungssystems angeordnet werden, das ein scheibenartiges Element oder einen Wafer z. B. in eine Teststation überträgt. In dieser Hinsicht ist die erfindungsgemäße Vorrichtung in der Lage, das scheibenartige Element mit seinen zangenartigen Armen von dem Handhabungssystem anzunehmen, zu halten und aufzubewahren, wobei es von dem Antriebsmechanismus angetrieben wird und wobei das entladene Handhabungssystem, nachdem es das scheibenartige Element oder den Wafer in den Armen der erfindungsgemäßen Vorrichtung platziert hat, einen weiteren Wafer beispielsweise von dem Aufspannkopf aufgreifen kann, der aus der Teststation kommt. Wenn diese Schritte abgeschlossen sind, ist die erfindungsgemäße Vorrichtung auf überaus vorteilhafte Weise in der Lage, den aufbewahrten Wafer mit seinen zangenartigen Armen auf der Ladeposition oder dem Aufspannkopf zu platzieren oder zu wechseln, der in die Teststation zu übertragen ist. Der gerade beschriebene Zyklus arbeitet natürlich auch anders herum. Somit kann jede Bewegung des Handhabungssystems ohne Wafer vermieden werden, wenn die erfindungsgemäße Vorrichtung eingesetzt wird.

Es sollte betont werden, dass erfindungsgemäß der Begriff scheibenartiges Element in seiner Bedeutung jede Art von Element umfasst, das mittels der erfindungsgemäßen Vorrichtung gewechselt oder übertragen werden kann oder das dafür ausgelegt ist, in dem erfindungsgemäßen Verfahren verwendet zu werden. Im Sinne der Erfindung können scheibenartigen Elemente somit zum Beispiel rund wie ein Wafer oder rechteckig wie eine Platte sein, oder sie können irgendeine geeignet Form aufweisen.

Hinsichtlich einer vorteilhaften Weiterentwicklung der erfindungsgemäßen Vorrichtung ist eine Hebelvorrichtung und/oder ein Spindelmittel vorgesehen, das die Bewegung der zangenartigen Arme steuert oder lenkt. Die Hebelvorrichtung und/oder das Spindelmittel gewährleisten zusammen mit dem erfindungsgemäßen Antriebsmechanismus somit zumindest eine Bewegung dem zangenartigen Arme in eine Halte- und in eine Freigabeposition und umgekehrt. Die Halteposition ist dadurch gekennzeichnet, dass die Arme in dieser Position bereit sind, ein scheibenartiges Element oder eine Wafer anzunehmen und/oder zu halten, während in der Freigabeposition die Arme geöffnet sind, so dass ein scheibenartiges Element durch die Arme geladen oder entladen werden kann. Dadurch ist gewährleistet, dass insbesondere in dem Fall, dass die Arme ein scheibenartiges Element oder einen Wafer aufladen oder ergreifen, der Abstand zwischen den Armen beziehungsweise den Armen und dem scheibenartigen Element derart ist, dass das scheibenartige Element nicht beschädigt wird.

Gemäß einer zusätzlichen vorteilhaften Weiterentwicklung der erfindungsgemäßen Vorrichtung ist der Antriebsmechanismus in eine Hubvorrichtung und einen Manipulatorantrieb unterteilt. Der Manipulatorantrieb bewirkt, dass die Arme eine zangenartige Bewegung in einer Ebene ausführen, während die Hubvorrichtung die Arme und/oder den Manipulator vorzugsweise auf und ab bewegt, d. h. in einer Richtung vorzugsweise senkrecht zu der durch die zangenartige Bewegung der Arme definierten Ebene. Beide Bewegungen und somit beide Vorrichtungen können vorteilhafterweise unabhängig gesteuert werden.

Hinsichtlich einer weiteren bevorzugten Ausführungsform der Erfindung ist vorgesehen, dass der Antriebsmechanismus oder der Manipulatorantrieb die Funktionalität umfasst, die Arme in zwei verschiedene Haltepositionen und in zwei, den Haltepositionen entsprechende Freigabepositionen bewegt. Diese Art von Funktionalität bietet die Möglichkeit, die erfindungsgemäße Vorrichtung für verschiedene Arten scheibenartiger Elemente zu verwenden, z. B. für Wafer mit unterschiedlichen Durchmessern. Insofern könnte die erfindungsgemäße Vorrichtung zum Beispiel für Wafergrößen mit einem Durchmesser von 200 mm oder von 300 mm verwendet werden.

In Verbindung damit sieht die Erfindung auch Verlängerungsglieder vor, die Teil der Arme sind und die es vorteilhafterweise gestatten, die Zufuhrweite oder den Abstand zwischen den Armen flexibel anzupassen. Dies eröffnet die Möglichkeit, die erfindungsgemäße Vorrichtung zum Wechseln von Scheiben nicht nur mit zwei oder drei verschiedenen Durchmessern, sondern mit allen Arten von Durchmessern zu verwenden.

Weitere bauliche Elemente der Erfindung, die die erfindungsgemäße Vorrichtung positiv weiterentwickeln, sind gegeben, wenn die Vorrichtung ein Greifmittel umfasst, das den Armen hilft, das scheibenartige Element zu ergreifen. Das Greifmittel kontaktiert die Ränder des scheibenartigen Elements, wenn es von der erfindungsgemäßen Vorrichtung oder den zangenartigen Armen ergriffen wird. Zu diesem Zweck umfasst das Greifmittel vorteilhafterweise zumindest einen gerillten, kreisförmigen Ringabschnitt, der an den Radius oder Durchmesser des zu greifenden Wafers angepasst ist.

Um eine kompakte Baugruppe bereitzustellen, umfasst die erfindungsgemäße Vorrichtung ein Gehäuse, in dem zumindest ein Teil des Antriebsmechanismus für die zangenartigen Armen untergebracht ist. Durch dieses sind Öffnungen vorgesehen, durch die sich die Arme erstrecken, um das scheibenartige Element zu ergreifen. Die Arme sind vorteilhafterweise außerdem so geformt, dass es möglich ist, die Vorrichtung beziehungsweise die Arme von vorne oder von hinten zu beladen. Die Vorderseite ist in dieser Hinsicht die Seite, zu der sich die Arme erstrecken und die Hinterseite ist die Seite gegenüber der Vorderseite.

Gemäß einer anderen Weiterentwicklung der Erfindung umfasst die erfindungsgemäße Vorrichtung oder der Antriebsmechanismus zumindest einen Antriebsmotor, der einerseits die vertikale Bewegung der zangenartigen Arme über den Hebelmechanismus und/oder die Spindel antreibt und andererseits auch die horizontale Bewegung der Arme antreibt.

Auf besonders vorteilhafte Weise umfasst die Erfindung auch Sensormittel, um das scheibenartige Element zu erfassen, d. h. um der Vorrichtung mitzuteilen, ob ein scheibenartiges Element sich in der erfindungsgemäßen Vorrichtung befindet oder nicht und/oder um die Position der zangenartigen Arme zu erfassen. Zu letzterem Zweck können Sensoren zum Beispiel paarweise relativ zu den Armen angeordnet werden, so dass sie in der Lage sind, zumindest zwei unterschiedliche Positionen der Arme zueinander anzuzeigen. Diesbezüglich könnte zum Beispiel einer der Sensoren die Halteposition des jeweiligen Arms und der andere die Freigabeposition des jeweiligen Arms anzeigen. Das gleich gilt, wenn die erfindungsgemäße Vorrichtung für scheibenartigen Elemente unterschiedlicher Durchmesser bemessen ist, wobei für jedes scheibenartige Element eine Halteposition und eine Freigabeposition über die Anordnung der Sensoren oder über Sensorablesungen definiert werden können. Zudem könnten Sensoren bereitgestellt werden, die die Höhe der Arme relativ zu einer definierten Höhe anzeigen.

Gemäß einem weiteren Aspekt der Erfindung umfasst die erfindungsgemäße Vorrichtung günstigerweise Steuermittel zur Steuerung der Bewegung der Arme und/oder der Motorantriebe etc. oder ist daran anschließbar. Hierzu sind geeignete Schnittstellen und zumindest ein Mikrokontroller vorgesehen.

Zusätzlich zu dem oben dargelegten, besteht eine weitere Aufgabe der vorliegenden Erfindung darin, ein Verfahren bereitzustellen, das durch die Verwendung der erfindungsgemäßen Vorrichtung die Verwendung komplexer Handhabungssysteme vermeidet, aber dennoch den Durchsatz erheblich erhöht.

Die Lösung für dieses Problem ist durch ein Verfahren nach Anspruch 14 gegeben.

Dort ist ein Verfahren zur Handhabung oder zum Transport von scheibenartigen Elementen, z. B. Wafern definiert, wobei eine oben beschriebene Vorrichtung in einem Austauschbereich zum Austauschen von scheibenartigen Elementen positioniert wird, wofür ein erstes scheibenartiges Elements mit ersten Transportmitteln von einer ersten Position zu dem Austauschbereich transportiert wird, in dem Austauschbereich das erste scheibenartige Element in die erfindungsgemäße Vorrichtung geladen wird, wobei nach oder parallel zu oder sogar vor der letzteren Beladung ein zweites scheibenartiges Element mit zweiten Transportmitteln zu dem Austauschbereich transportiert wird, wobei das zweite scheibenartige Element nach dem Entladen des ersten Transportmittels von dem zweiten Transportmittel auf das erste Transportmittel geladen wird, und nach dem Entladen des zweiten Transportmittels das von der erfindungsgemäßen Vorrichtung ergriffene, geladene oder beladene erste scheibenartige Element von der erfindungsgemäßen Vorrichtung zu dem zweiten Transportmittel übertragen wird, wobei, wenn dies getan ist, das zweite scheibenartige Element mittels des zweiten Transportmittels zu einer zweiten Position transportiert werden kann. Der Zyklus kann von neuem beginnen.

Eine weitere Aufgabe der Erfindung besteht darin ein Handhabungssytem zur Ausführung des gerade beschriebenen Verfahrens bereitzustellen. Das erfindungsgemäß Handhabungssystem umfasst entsprechende Mittel zur Durchführung des Verfahrens. So kann sie insbesondere ein x-y-Gestell oder einen Aufspannkopf und/oder einen Roboter umfassen, um entweder das erste oder das zweite Transportmittel zu ersetzen.

### KURZE BESCHREIBUNG DER ZEICHNUNG

Die Erfindung wird zusammen mit weiteren Merkmalen und ihren zusätzlichen Vorteilen am besten im Rahmen der folgenden Beschreibung verstanden werden.

Gezeigt sind in:
Fig. 1 eine Querschnittsansicht einer Ausführungsform der erfindungsgemäßen Vorrichtung, wobei die zangenartigen Arme in der oberen Position sind,
Fig. 2 der Querschnitt wie in Fig. 1 gezeigt, wobei die zangenartigen Arme in der unteren Position sind,
Fig. 3 eine Unterseitenansicht von Fig. 1 einschließlich des Wafers, der Arme und der Greifer der Arme,
Fig. 4 eine Draufsicht einer Steuerkurvenscheibe mit zwei Steuerkurvenringen,
Fig. 5 eine Topographie oder ein Profil der Steuerkurvenringe der Steuerkurvenscheibe gemäß Fig. 6,
Fig. 6 einen Platzierungszyklus der Arme,
Fig. 7 ein Bewegungsablaufdiagramm der Arme,
Fig. 8 eine Perspektivansicht der Vorderseite einer weiteren erfindungsgemäßen Ausführungsform,
Fig. 9 eine Perspektivansicht der Rückseite der Ausführungsform von Fig. 8,
Fig. 10 eine schematische Draufsicht des Manipulatorantriebs zusammen mit den zangenartigen Armen von Fig. 8 mit der Ausnahme, dass der Manipulatorantrieb jeweils nur ein Stellglied zum Antrieb der Gewindespindeln beziehungsweise der zangenartigen Arme umfasst,
Fig. 11 eine schematische Draufsicht, wie in Fig. 10 gezeigt, mit der Ausnahme, dass der Manipulatorantrieb jeweils eine Manipulator-Riemenantrieb-Baugruppe zum Antrieb der Gewindespindeln beziehungsweise der zangenartigen Arme umfasst,
Fig. 12 eine schematische Draufsicht einer weiteren Ausführungsform des Manipulatorantriebs und der zangenartigen Arme einer erfinderischen Wechselvorrichtung, wobei der Manipulatorantrieb einen Getriebeantrieb und eine Hebelvorrichtung zum Antreiben der zangenartigen Arme umfasst,
Fig. 13 der Handhabungsvorgang, wenn eine erfindungsgemäße Vorrichtung verwendet wird, für den Fall, dass die erfinderische Vorrichtung zuerst von vorn beladen wird,
Fig. 14 der Handhabungsvorgang von Fig. 8 mit dem Unterschied, dass die erfinderische Vorrichtung zuerst von hinten beladen wird.

### AUSFÜHRLICHE BESCHREIBUNG DER ZEICHNUNGEN

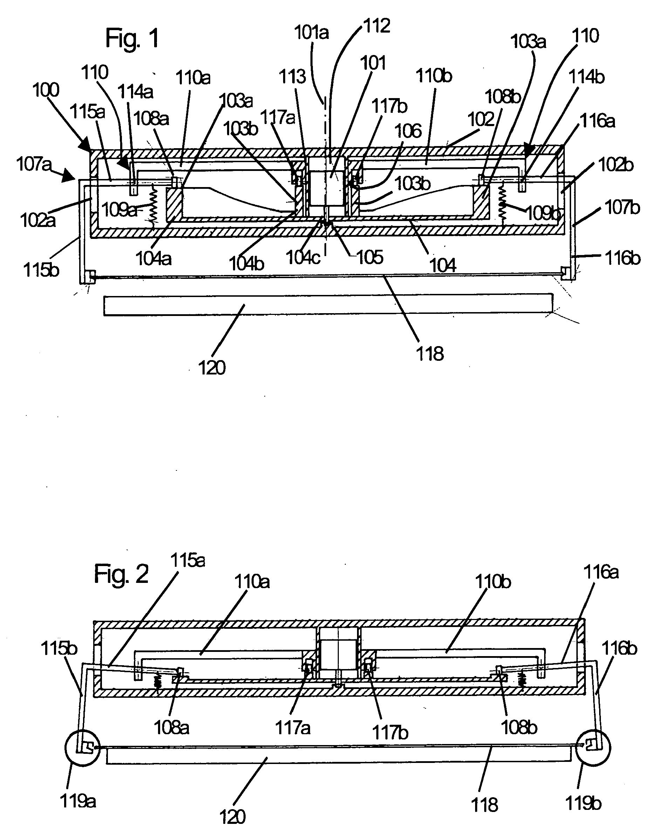

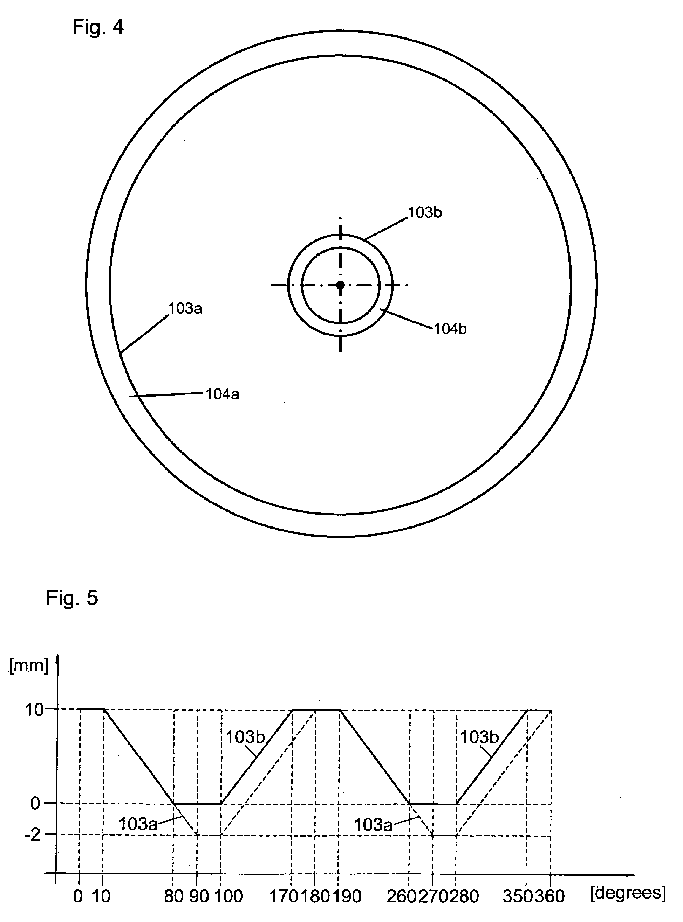

Die Figuren 1 und 2 zeigen eine Gestaltung der erfindungsgemäßen Vorrichtung, die im nachfolgenden als schnelle Wechselstation (FSS-1) bezeichnet wird. Die erfindungsgemäße schnelle Wechselstation umfasst einen Antriebsmechanismus 100 und zangenartige Arme 107a und 107b. Die Antriebsleistung des Antriebsmechanismus 100 wird von einem Motor 101 geliefert. Der Motor 101, der an dem Oberteil des Gehäuses 102 befestigt ist, ist in der Mitte des Gehäuses 102 des Antriebsmechanismus 100 angebracht und dreht die Steuerkurvenplatte 104. Das Gehäuse 102 weist eine Zylindergehäusestruktur mit Öffnungen 102a und 102b in ihrem Zylindermantel auf, wobei die Öffnungen 102a und 102b einander gegenüberliegend angeordnet sind. Die Antriebsachse 101a des Motors 101 ist in der Montagebohrung 104c der Platte 104 befestigt. Die Scheibe oder Platte 104 weist zwei höhere Kreise oder Ringe 104a und 104b mit einer höhenveränderlichen Topographie auf, die die Steuerkurvenstrukturen 103a und 103b auf der Scheibe 104 (siehe auch Fig. 4) wiedergeben. Die drehende Platte 104 und die Antriebswelle 101a werden durch das Lager 105 in der Mitte des unteren Teils oder der Bodenseite des Gehäuses 102 getragen. Innerhalb des Gehäuses ist ein mittig angeordneter Raum 112 vorgesehen, der den Motor 101 aufnimmt. Der Raum wird von der Wand 113, die den Motor umgibt und an die z. B. zylindrische Geometrie des Motors angepasst ist, zusammen mit dem oberen Teil der oberen Fläche des Gehäuses 102 gebildet, an der die Wand 113 integral angebracht ist und von dem sie sich nach unten zu dem Boden des Gehäuses und der Platte 104 erstreckt. Die Wand 113, die mit dem Motor 101 an ihrer Innenseite Kontakt hat, ist an ihrer Außenseite der innere Teil eines Gleitlagers 106. Das Gegenstück oder Außenteil dieses Gleitlagers 106 ist die Innenseite einer Öffnung der Trägerstruktur 110 (110a und 110b), die mit zwei Rollen 117a und 117b auf dem inneren Kreis 104b mit der Steuerkurvenstruktur oder dem Konturprofil 103b aufsitzt. Diese Trägerstruktur 110 hält zwei Arme 107a und 107b. Diese Arme 107a und 107b sind von rechtwinkliger Form und umfassen jeweils zwei Beine 115a, 115b und 116a, 116b, nämlich die oberen Beine 115a und 116a und die Seitenbeine 115b und 116b.

Aus Gründen der Einfachheit wird im folgenden nur die Struktur und Funktion eines der Arme 107a und 107b beschrieben, wobei die Arme 107a und 107b in Struktur und Funktion gleich sind, abgesehen davon, dass sie einander gegenüberliegend und spiegelbildlich zueinander angeordnet sind.

Das obere Bein 115a des Arms 107a wurde durch die Öffnung 102a des Gehäuses 102 eingeführt oder erstreckt sich durch sie und ist beweglich an dem Drehpunkt 114a des Haltearms 110a der Trägerstruktur 110 angebracht, um eine Hebelvorrichtung zu bilden, die es gestattet, dass das obere Bein 115a unter definierten Bedingungen, die später beschrieben werden, seinen Winkel relativ zu der horizontalen Linie beziehungsweise zu dem Haltearm 110a ändert. Das obere Bein 115a weist mit seinem Ende innerhalb des FSS-1-Gehäuses 102 eine an seinem Ende drehbar angebrachte Rolle 108a auf, wobei die Rolle 108a von der zweiten Topographie 103a der drehenden Platte 104 getragen wird. Das obere Bein 115a und damit auch der Arm 110a der Trägerstruktur wird mit der Feder 109a unten gehalten oder gegen die Konturkreise 104a oder die Steuerkurvenstruktur 103a gepresst. Zu diesem Zweck ist die Feder 109a an dem oberen Bein 116a und dem Bodenteil des Gehäuses 102 zwischen der Rolle 108a und dem Lagerdrehpunkt 114a an einem Punkt befestigt, der von der auf das obere Bein 115a beziehungsweise das Konturprofil 103a auszuübenden Kraft abhängt.

Durch Drehen der Platte 104 werden daher die Rollen 117a und 117b der Trägerstruktur 110 der Topographie der Steuerkurvenstruktur 103b folgen und die Rollen 108a und 108b der Arme 107a und 107b werden der Topographie der Steuerkurvenstruktur 103a folgen, wobei die Arme 107a, 107b eine zangenartige Bewegung ausführen. Der Unterschied zwischen den zwei Profilen der zwei Steuerkurvenstrukturen 103a und 103b bewirkt eine Änderung der Relativposition zwischen der Trägerstruktur 110 und den Armen 107 (107a und 107b). In dieser Hinsicht zeigt die Figur 1, dass die Trägerstruktur 110 durch das Drehen der Platte 104 nach oben geschoben wird und die Arme mit ihren oberen Beinen 115a und 116a ebenso auf die gleiche Höhe geschoben werden. Dies ist der Zustand, in dem die Arme einen Wafer 118 halten können oder, falls kein Wafer vorhanden ist, einen Wafer von einem Roboterhandhaber eines Waferhandhabungssystems annehmen und aufbewahren können.

Figur 2 zeigt die Trägerstruktur nach der Drehung der Platte 104 unten, und der Träger 103a der Arme befindet sich sogar noch weiter unten, weil in der in Figur 2 gezeigten Winkelposition der Platte 104 die Rollen 108a und 108b der Arme 107a beziehungsweise 107b nach unten auf eine Höhe geschoben werden, die niedriger als diejenige der Rollen 117a und 117b ist, woraus sich eine Bewegung des Arms 107b entgegen dem Uhrzeigersinn und eine Bewegung des Arms 107a Uhrzeigersinn bis zu einem definierten Winkel ergibt, der von den Höhenunterschieden der Steuerkurvenstruktur in der unteren Position abhängt, wodurch die Seitenbeine 115b und 116b wie die Arme einer Zange zur Seite geschoben werden. In diesem Fall werden die Arme 107 (107a und 107b) in einer unteren Position geöffnet, um den Wafer 118 für einen Aufspannkopf 120 freizugeben oder den Wafer 118 von dem Aufspannkopf 120 anzunehmen.

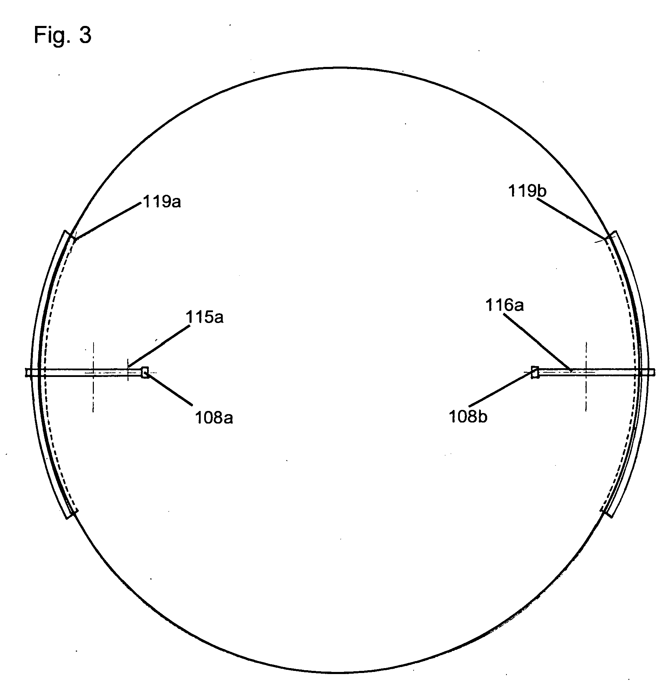

Die Greifer oder Haltebereiche 119 (119a und 119b) der Arme zum Halten des Wafers bestehen aus zwei kreisförmigen Ring- oder Randabschnitten 119a und 119b, deren Radius an denjenigen des Wafers angepasst ist (Fig. 3). In der Querschnittsansicht der Figuren 1 oder 2 ist zu sehnen, dass die Ringabschnitte 119a, 119b Halterillen umfassen, wodurch der Querschnitt der Rillen geringförmig von einem "L" abweicht. In dieser Hinsicht bildet der vertikale Teil einen Winkel mit dem unteren Teil, der größer als 90° ist. Der Wafer kann somit einfach in dem Haltebereich 119 ergriffen werden, ohne ihn zu quetschen oder zu beschädigen. In der Halteposition der Arme 107 sitzt der Wafer auf dem unteren Teil der Rille und der vertikale Teil oder die erhabene Kante der Rille hält den Wafer 118 während der Bewegung in einer definierten Position, d. h. Radius. Dies ist in Fig. 3 noch besser zu sehen. Dort markieren die gestrichelten Linien das Ende der Greifer oder Haltebereiche.

Der Greifmechanismus des FSS-1 ist derart, dass die Arme 107 sich weit genug öffnen und langsam genug schließen, wenn die Arme 107a und 107b nach oben in die obere oder Halteposition geschoben werden, wodurch die Greifer 119 den Wafer passieren, ohne ihn auf ihrem Weg nach oben zu berühren.

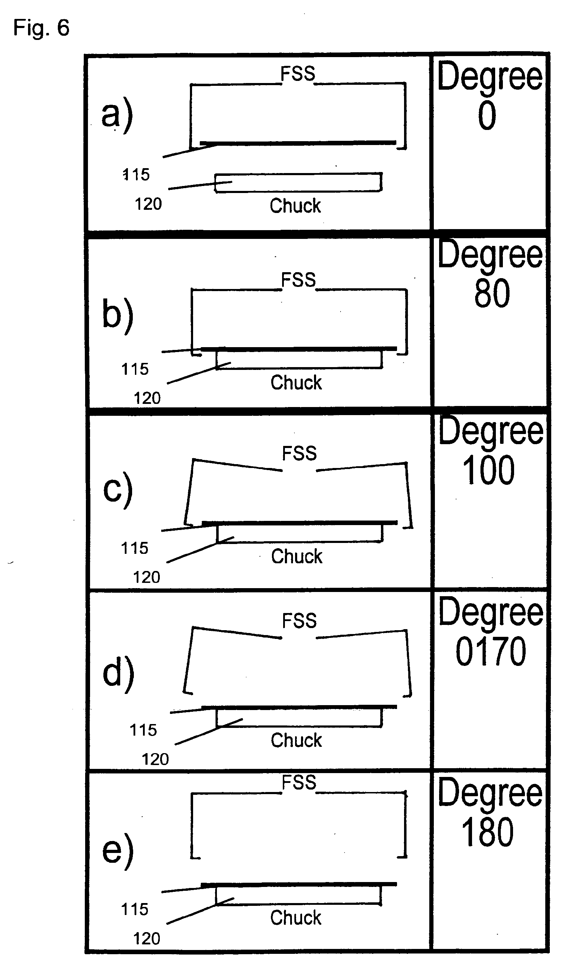

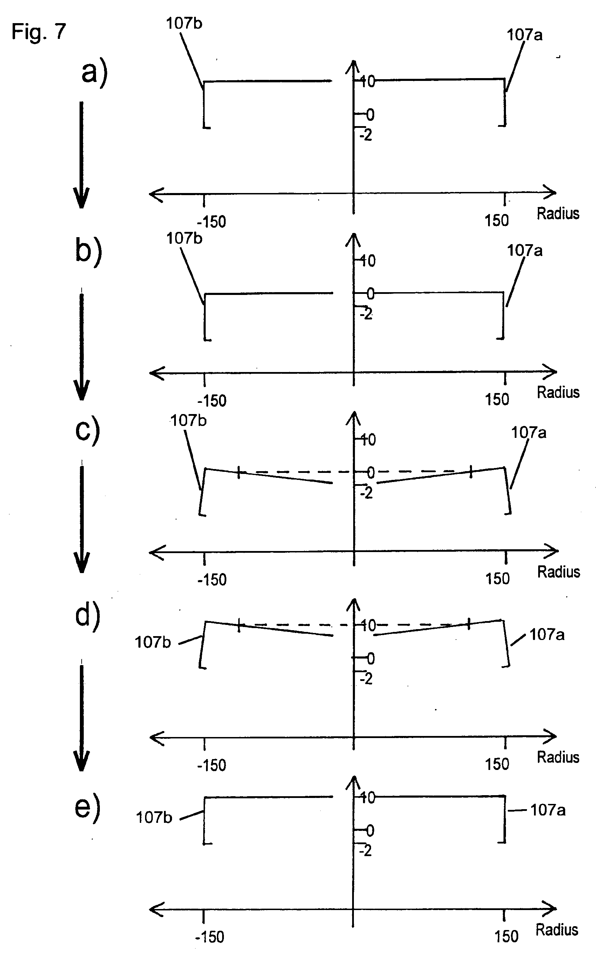

Um diese Bewegung zu erzielen, ist ein Profil oder eine Steuerkurvenstruktur 103a und 103b der Kontur wie in Fig. 5 gezeigt vorgesehen. Fig. 5 zeigt teilweise eine Projektion der Steuerkurve 103a und 103b der Profilringe 104a und 104b (Fig. 4). Von 0° bis 10° sind beide Konturen 103a, 103b stabil auf einer Höhe von 10 mm. Von 10° bis 80° fallen beide Profile parallel ab, wobei in der Projektion der Fig. 5 die Konturlinien zusammenfallen. Auf diese Weise führt die Drehung der Platte oder Scheibe 104 zu einer Abwärtsbewegung der Arme ohne Öffnung der Arme (siehe auch Figuren 6a, 7a und 6b, 7b). Nach 80° fällt die äußere Kontur 103a stärker ab als die innere Kontur 103b, d. h. auf minus 2 mm. Die Arme 107a und 107b drehen sich daher um ihre Drehpunkte 114a und 114b, um die Greifer 119 beziehungsweise die Arme zu öffnen (Figur 6c, 7c). Von 100° bis 170° bewegen sich beide Profile parallel mit einer konstanten Differenz, so dass die Arme nach oben gehen, aber offen bleiben (Figur 6d, 7d). Von 170° bis zu 180° kommt das äußere Profil 103a auf die gleiche Höhe wie das innere 103b. Die Arme schließen sich wieder (Figur 6e, 7e).

Eine weitere Bewegung der Platte 104 in die gleiche Richtung bis zu 360° würde die oben beschriebene Übertragungsbewegung wiederholen. Falls die Bewegung der Platte 104 umgekehrt wird, würde anstelle des beschriebenen Platzierungszyklus ein Aufgreifzyklus gestartet, der bei der Endposition des Platzierungszyklus beginnt und bei dem Start oder der oberen Position des Platzierungszyklus endet.

Diese Funktionalität ist auch in den Figuren 7a bis 7e gezeigt; die Arme 107 (107a und 107b) bewegen sich zunächst von einer Höhe von 10 mm nach unten auf den Punkt des Nullniveaus, der die maximale untere Positionierung der Arme 107 markiert. Eine weitere Drehung der Scheibe führt zu der Öffnung der Arme und zur Platzierung des Wafers auf dem Aufspannkopf. Durch Rückwärtsdrehen, d. h. von der 360° Position zu der 180° Position oder von der 180° Position zu der 0° Position kann ein Wafer von dem Aufspannkopf aufgegriffen und zu der oberen oder Aufbewahrungsposition gebracht werden.

Die Funktionalität gestattet somit ein schnelles Wechseln von Wafern am Aufspannkopf mit einem Handhabungswerkzeug, das nur einen Wafer handhaben kann: Dadurch legt der Roboter mit nur einem Arm den neuen Wafer in die FSS-1 ein, die geschlossen ist, indem der Wafer in die korrekte Mittelposition mit einer erhöhten Höhe bewegt wird, um die Außenränder der Waferhaltestruktur 119a und 119b zu überwinden. Dann platziert der (nicht gezeigte) Roboter den Wafer auf der Trägerstruktur. Dann greift der Roboter den alten Wafer vom Aufspannkopf. Nachdem der Wafer von dem Aufspannkopf entfernt ist, platziert die FSS-1 den Wafer auf dem Aufspannkopf 120, indem sie sich durch die Sequenz von Figur 6a bis 6e oder 7a bis 7e bewegt.

Die FSS-1 ist dann bereit, den nächsten Wafer anzunehmen, und der schnelle Wechselzyklus kann von vorne beginnen.

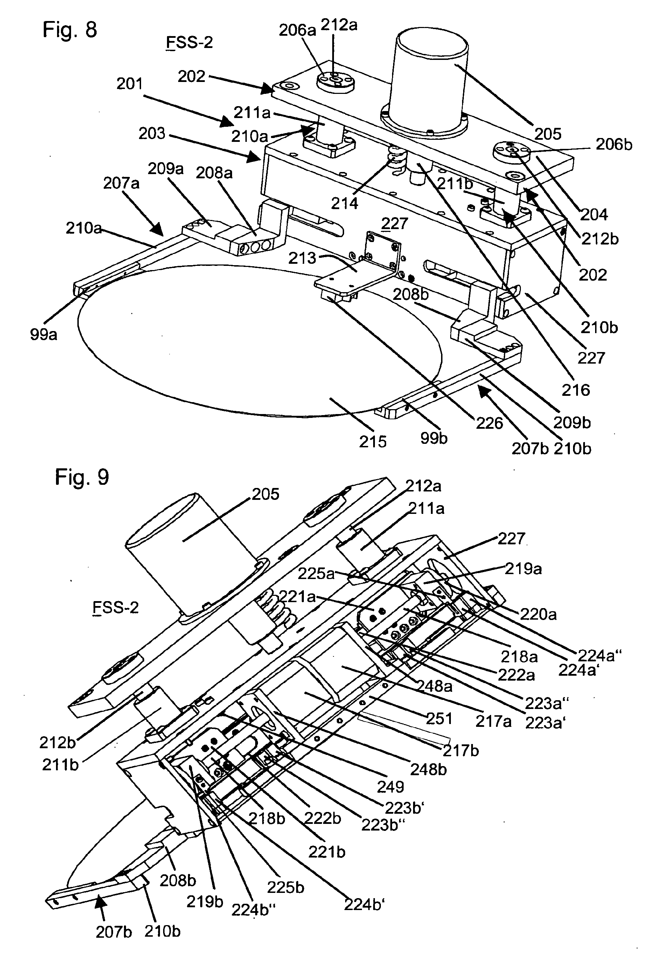

Im folgenden wird Bezug auf Fig. 8 genommen, in der eine vorderseitige Perspektivansicht einer weiteren Ausführungsform der erfindungsgemäßen Vorrichtung FSS-2 gezeigt ist. Die in Fig. 8 gezeigte FSS-2 umfasst zangenartige Arme 207 (rechter Arm 207a und linker Arm 207b) und einen Antriebsmechanismus 201. Jeder der Arme 207 besteht aus einem Führungselement 208 (208a rechter Arm und 208b linker Arm), einem Verlängerungsglied 209 (209a rechter Arm und 209b linker Arm), einem Bein 210 (210a rechter Arm und 210b linker Arm) und einem Greifer 99 (99a rechter Arm und 99b linker Arm). Der Antriebsmechanismus 201 besteht aus einer Hubvorrichtung 202 und einem Manipulatorantrieb 203. Der Zweck des Manipulatorantriebs besteht darin, die Arme 207a, 207b geeignet zu steuern, zu lenken oder anzutreiben, so dass die Greifer 99a, 99b in einer zangenartigen Bewegung einen Wafer von einem Aufspannkopf oder Roboter, etc. aufgreifen, halten und freigeben können.

Die Hubvorrichtung 202 umfasst eine rechtwinklige Grundplatte, an der ein Stellglied 205 mittig angebracht ist. An den vorderseitigen Ecken der Grundplatte 204 umfasst die Grundplatte 204 Durchgangslöcher zur Anbringung der Grundplatte. Das Stellglied 205 ist ein lineares Stellglied, das auf einer Seite eine Spindel 216 aufweist. Um das Stellglied 205 auf der Grundplatte 204 unterzubringen, umfasst die Grundplatte 204 zudem ein mittig positioniertes Durchgangsloch, durch das sich die Stellgliedspindel 216 erstreckt. Die Funktion der Hubvorrichtung 202 besteht darin, den Manipulatorantrieb 203 in einer Richtung senkrecht zu einer Ebene anzuheben, die von der Bewegung der Arme 207a und 207b definiert wird. Die Hubvorrichtung 202 ist daher an der Oberseite des Gehäuses 227 des Manipulatorantriebs 203 über ihre Spindel 216 und lineare Führungen 210 (lineare Führung 210a auf der rechten Seite und lineare Führung 210b auf der linken Seite des Stellglieds) befestigt. Die linearen Führungen 210a, 210b bestehen aus einem Stift 212 (212a und 212b) (Fig. 9) und einer Führung 211 (211a und 211b), die die Hubbewegung führen. Die Stifte 212 sind symmetrisch zu dem linearen Stellglied 205 angeordnet und erstrecken sich durch jeweilige Löcher, die von der Grundplatte 204 umfasst werden. Die Stifte 212 sind an der Grundplatte mittels Klammern 206 (206a und 206b) angebracht und wirken mit den Führungen 211 zusammen, die auf der oberen Fläche des Gehäuses 227 mittels Flanschen angebracht sind. Das Stellglied 205 kann somit mit seiner Spindel das Gehäuse 227 des Manipulatorantriebs 203 auf- und abwärts bewegen, wenn das Stellglied über das Kabel 214 geeignet mit Strom versorgt wird. Auf der Vorderseite des Gehäuses 227 ist in mittiger Position auf der Vorderseite ein Halter 213 an dem Gehäuse 227 angebracht, der einen Abtastsensor 226 trägt, der das Vorhandensein von Wafern 215 erfasst oder prüft, d. h. er erfasst, ob die Arme 207 einen Wafer tragen oder nicht. Der Sensor 226 ist an dem freien Ende des Halters 213 befestigt, wobei der Halter sich von dem Gehäuse 227 so weg erstreckt, dass zumindest Wafer oder Scheiben mit zwei verschiedenen Durchmessern wie beispielsweise 200 mm und 300 mm erfasst werden können.

Es wird nun zu Fig. 9 übergegangen, in der die Rückseite der Wechelvorrichtung FSS-2 von Fig. 8 zu sehen ist. Man beachte, dass die Rückplatte des Gehäuses 227 des Manipulatorantriebs entfernt wurde. Fig. 9 zeigt daher die Funktionselemente des Manipulatorantriebs 203 frei. Darin können zwei Seiten unterschieden werden. Der Mechanismus auf der rechten Seite treibt den rechten Arm 207a an und der Mechanismus auf der linken Seite treibt den linken Arm 207b an. Die technischen Eigenschaften beider Seiten sind die gleichen. Daher ist die folgende Beschreibung der technischen Teile auf nur die rechte Seite beschränkt. Der Antriebsmechanismus auf der rechten Seite umfasst einen Motor oder ein Linearstellglied 217a (217b), der von einer Winkelstütze 248a (248b) gehalten wird und der eine Gewindespindel 218a (218b) treibt, die mit dem Innengewinde der Haltermutter 219a (219b) zusammenwirkt, wodurch abhängig von der Richtung der Gewindespindel 218a (218b) die Haltermutter 219a entweder nach links oder nach rechts bewegt wird. Die Gewindespindelmutter 220a (220b) sichert die Haltermutter 219a (219b). Die Haltermutter 219a (219b) selbst ist mit dem linearen Schlitten 221a (221b) verbunden, der mit dem Führungselement 208a (208b) (siehe Fig. 8) verbunden ist. Der lineare Schlitten 221a (221b) wird durch die lineare Führung parallel zu der Gewindespindel 218a (218b) geführt. Zwei Paare von Endsensoren 223a (223b) und 224a (224b) sind längs des Führungswegs des linearen Schlittens 221a (221b) angeordnet. Die Sensoren 223a (223b), 224a (224b) wechselwirken mit dem Reitersensor 225a (225b), der an dem linearen Schlitten 221a (221b) angebracht ist. Das erste Paar von Sensoren 223a (223b) ist so längs des Führungswegs positioniert, dass ein 200 mm breiter Wafer von den Armen des Greifers 99b entweder freigegeben/aufgegriffen oder gehalten werden kann. Das bedeutet, dass, wenn die Haltermutter 219a (219b) beziehungsweise das Führungselement 208a (208b) zur linken Seite bewegt wird (das gleiche gilt, wenn das Führungselement 208b der linken Seite nach rechts bewegt wird), der innere Sensor 223a' (223b') des Paares 223a (223b) über den Reitersensor 225a (225b) anzeigt, dass der Arm 207a (207b) oder der Greifer 99a (99b) die richtige Position zum Halten des Wafers 215 (Fig. 8) hat, während, wenn das Führungselement 208a (208b) oder der Greifer 99a (99b) nach rechts (links) bewegt wird, der äußere Sensor 223a'' (223b'') des Paares 223a (223b) über den Reitersensor 225a (225b) anzeigt, dass das Führungselement 208a (208b) oder der Greifer 99a (99b) sich weit genug bewegt hat, so dass keine Störung mit dem auf einem Aufspannkopf verbliebenen oder von einem Aufspannkopf aufzugreifenden Wafer vorkommt und somit auf alle Fälle keine Schädigung des Wafers 215 auftreten wird. Das zweite Paar von Sensoren 224a (224b) besitzt die gleiche Funktionalität für Wafer oder Scheiben mit einem Durchmesser von 300 mm. Die erfindungsgemäße Wechselvorrichtung umfasst somit die Möglichkeit scheibenförmige Elemente oder Wafer unterschiedlicher Durchmesser zu wechseln. Darüber hinaus ist ein weiterer Sensor oder Endschalter 249 an der Innenseite der oberen Platte des Gehäuses 227 vorgesehen, der den Abstand zwischen dem Manipulatorantrieb 203 und der Hubvorrichtung 202 anzeigt.

Eine weitere vorteilhafte Eigenschaft der FSS-2 gemäß der Figuren 8 und 9 ist der Umstand, dass die erfindungsgemäße Wechselstation sowohl von vorn als auch von hinten beladen werden kann. Baulich ist dies durch den Umstand vorgesehen, dass die Arme 207a und 207b so ausgebildet und an dem Manipulatorantrieb 203 angehängt sind, dass die Greifer 99a, 99b von der Vorderseite und der Rückseite des Gehäuses 227 frei zugänglich sind. Für diese Funktion ist der Teil der Führungselemente 208a und 208b, der sich durch die Führungsöffnungen des Gehäuses 227 erstreckt, gekröpft, und die Beine 210a, 210b sind an den einstellbaren Verlängerungsgliedern 209a, 209b angebracht, die die jeweiligen Führungselemente 208a, 208b und die Beine 210a, 210b verbinden, so dass ein Versatz der Greifer 99a, 99b und der Beine 210a, 210b relativ zu der Außenseite der Grundplatte 251 des Gehäuses 227 erreicht wird. Der Versatz beträgt vorzugsweise 10 mm.

Obschon es in Fig. 8 und Fig. 9 nicht gezeigt ist, kann die dargestellte Vorrichtung natürlich geeignete Schnittstellen und Kabel umfassen, die zur Fernsteuerung der Bewegungen der Vorrichtung mit dieser verbunden sind.

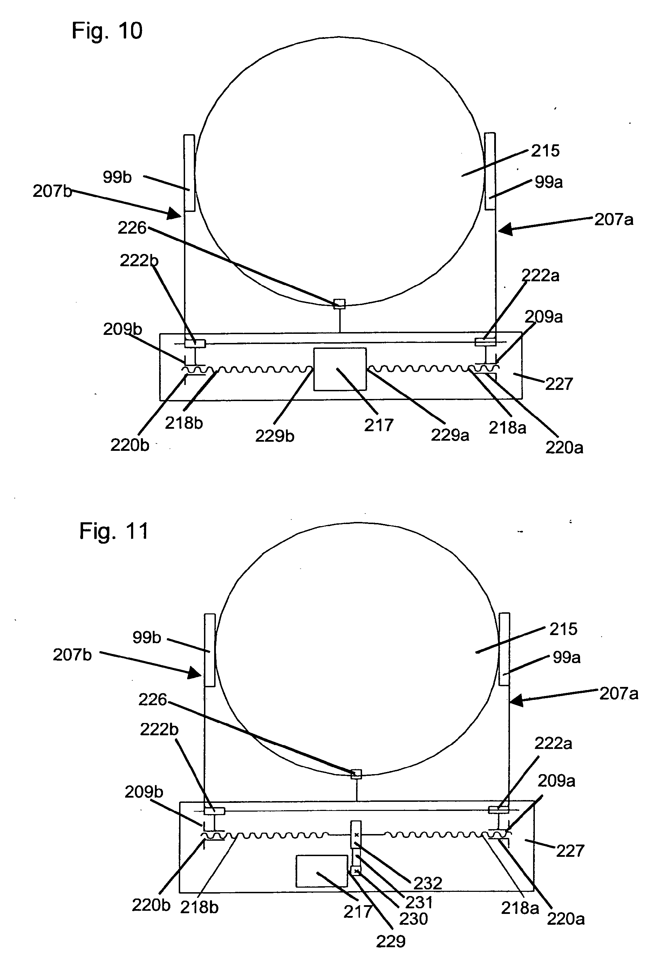

Eine im Vergleich zu den Figuren 8 und 9 geringfügig unterschiedliche Ausführungsform der Erfindung ist in Fig. 10 gezeigt. Dort ist eine schematische Draufsicht des Manipulatorantriebs zusammen mit den zangenartigen Armen von Fig. 8 dargestellt, die als Unterschied den Umstand zeigt, dass nicht zwei Motoren oder lineare Stellglieder 217a, 217b verwendet werden, sondern, dass nur ein Stellglied 217 das Gewindespindelpaar 218a, 218b und damit die Arme 207 oder Greifer 99 auf der rechten und linken Seite in den Figuren 8 und 9 antreibt. Um die zangenartige Bewegung der Arme 207a und 207b zu erzielen, weisen die Gewindespindeln jedoch vorzugsweise unterschiedliche Gewinde auf, d. h. das Gewindespindelpaar könnte zum Beispiel rechts 218a ein linkshändiges Gewinde und links 218b ein rechtshändiges Gewinde aufweisen und umgekehrt. Die gleiche Wirkung könnte natürlich erzielt werden, wenn das einzelne Stellglied oder der Motor 217 in der Lage wären, zwei unterschiedliche Antriebsrichtungen für das Gewindespindelpaar 218a und 218b mit jeweils der gleichen Gewindesteigung bereitzustellen. Wenn es durch den Motor 217 angetrieben wird, bewirkt das Gewindespindelpaar 218a und 218b somit eine antiparallele zangenartige Bewegung der Arme 207a, 207b.

Bei der Ausführungsform der Fig. 11 ist der einzelne Motor oder das Stellglied 217 mit zwei Antriebswellen 229a und 229b (Fig. 10) für das Gewindespindelpaar 218a, 218b durch einen Motor 217 mit nur einer Antriebswelle 229 ersetzt, die eine Riemenscheibe 230 antreibt, die mittels eines Riemenantriebs 231 eine angetriebene Riemenscheibe 232 in Gang setzt. Die angetriebene Riemenscheibe ist wie bei den Motoren gemäß Fig. 8 bis 10 axial mit dem Gewindespindelpaar 218a und 218b verbunden. Diese Art von Aufbau liefert nur eine Drehrichtung der angetriebenen Riemenscheibe 232 und des Gewindespindelpaars 218a und 218b. Das Gewindespindelpaar 218a und 218b muss daher für eine zangenartige Bewegung der Arme 207a und 207b entgegengesetzte Gewindesteigungen aufweisen.

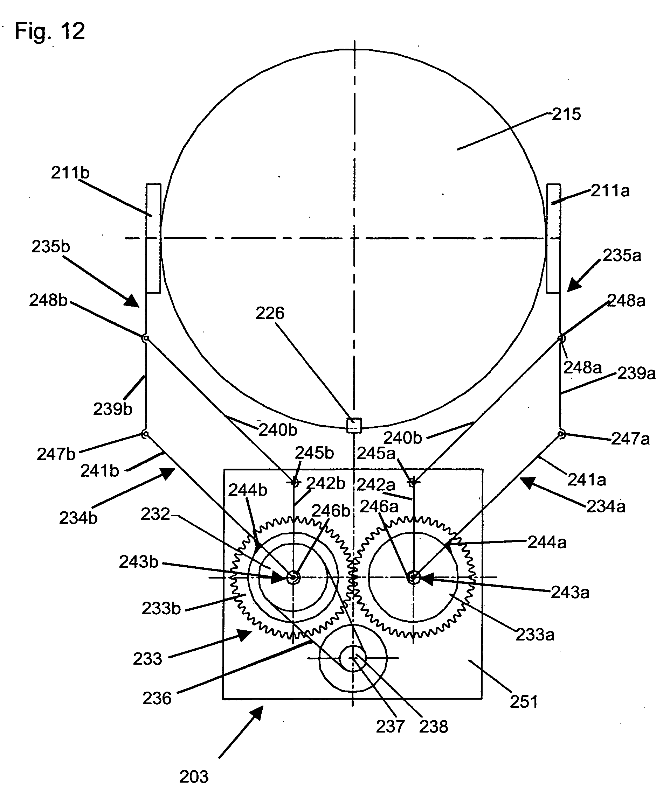

Fig. 12 zeigt wie die Figuren 10 und 11 unter Weglassung der Hubvorrichtung 202 (Fig. 8, 9) eine schematische Draufsicht einer weiteren Ausführungsform des Manipulatorantriebs 203 und der zangenartigen Arme, wobei wie in den Figuren 10 und 11 die Hubvorrichtung die gleiche bleibt wie in den Figuren 8 und 9. Der Manipulatorantrieb 203 in Fig. 12 umfasst ein Zahnradgetriebe 233 und eine Hebelvorrichtung 234 (234a und 234b) zum Antrieb der zangenartigen Arme 235 (235a und 235b). Das Zahnradgetriebe 233 besteht aus zwei Zahnrädern 233a und 233b, die kämmen. Eines der Zahnräder 233b wird durch eine Riemenscheibe 238 über die Riemenscheibe 232 angetrieben, die eine rückwärtige Position innerhalb des Manipulators 203 auf der Symmetrieachse des Wechselns aufweist. Diese Riemenscheibe 238 wird über den Riemen 236 angetrieben, der die Bewegung einer Antriebsriemenscheibe 238 überträgt, die an einem Stellglied oder Motor 237 angebracht ist und davon angetrieben wird.

Die Hebelvorrichtung 234 der Fig. 12 umfasst zwei Hebelstrukturen 234a und 234b. Teil der Hebelvorrichtung oder der Hebelstrukturen 234a und 234b sind zangenartige Arme 235a und 235b. Jede der Hebelstrukturen 234a und 234b bildet ein Parallelogramm von vier Hebeln 240, 241, 242 einschließlich der Teile 239a und 239b der Arme 235a und 235b. Bei jeder der Hebelstrukturen 234 werden zum Greifen des Wafers mittels der Greifer 99a und 99b die Arme 235 und damit auch die Teile 239 (239a und 239b) in eine Position parallel zu einer Tangente an die Kante der Scheibe oder des Wafers 215 gebracht. Jede der Hebelstrukturen 234a und 234b umfasst vier Zylindergelenke, die die Ecken des Parallelogramms bilden. Die Gelenke 245 und 246 an den Enden der zu den Armteilen 239a und 239b parallelen Hebel 242a und 242b sind lokal innerhalb des Manipulatorantriebs 203 fixiert, wobei die Hebel 242 sich parallel zu den Zahnrädern 233 erstrecken und wobei die Gelenke 246a und 246b an den Enden der Hebel 242a und 242b gegenüber dem Wafer lokal an den Naben 243a und 243b der Zahnräder 233a und 233b befestigt sind. Zudem ist bezüglich der Hebelvorrichtung 234a (234b) der Hebel 241a (241b auf der linken Seite), der parallel zu dem Hebel 240a (240b auf der linken Seite) ist, an dem Ritzel oder Zahnrad 233a (233b auf der linken Seite) mittels des Befestigungspunktes 244 angeheftet.

Auf der Basis der oben beschriebenen Strukturelemente der Ausführungsform nach Fig. 12 ist vorgesehen, dass, wenn das Stellglied 237 das linke Zahnrad 233b nach links antreibt oder dreht, sich das rechte Zahnrad 233b nach rechts drehen wird. Da die Hebel 241a und 241b an den jeweiligen Zahnrädern 233a und 233b befestigt sind und gemeinsam an den Naben 243a und 243b befestigt sind, werden diese Hebel ebenso in die jeweilige Richtung gedreht, d. h. der Hebel 241a wird um den Drehpunkt 243a nach rechts drehen und der Hebel 241b wird um den Drehpunkt 243b nach links drehen, worauf die Hebel 240a und 240b, die parallel zu den Hebeln 241a und 241b sind, der Bewegung der Hebel 241a und 241b um die befestigten Gelenke 245a und 245b folgen werden. Indem zum Beispiel die Hebel 241b und 240b nach links gedreht werden, wird der Abstand ihrer freien Enden 247b und 248b relativ zu dem Wafer 215 erhöht, woraus sich eine Bewegung des Arms 235b nach links ergibt. Da die Hebel 241b und 240b sich um den gleichen Winkel nach links drehen, gibt es einen parallelen Versatz des Arms 235 nach links. Die Funktionsbeschreibung für die linke Hebelstruktur 235b gilt auch für die rechte Hebelstruktur mit der Ausnahme, dass die Hebel in entgegengesetzte Richtungen wirken. Dies ist natürlich notwendig, um die zangenartige Bewegung der Arme zu erzielen, nach der der Wafer 215 ergriffen oder freigegeben wird.

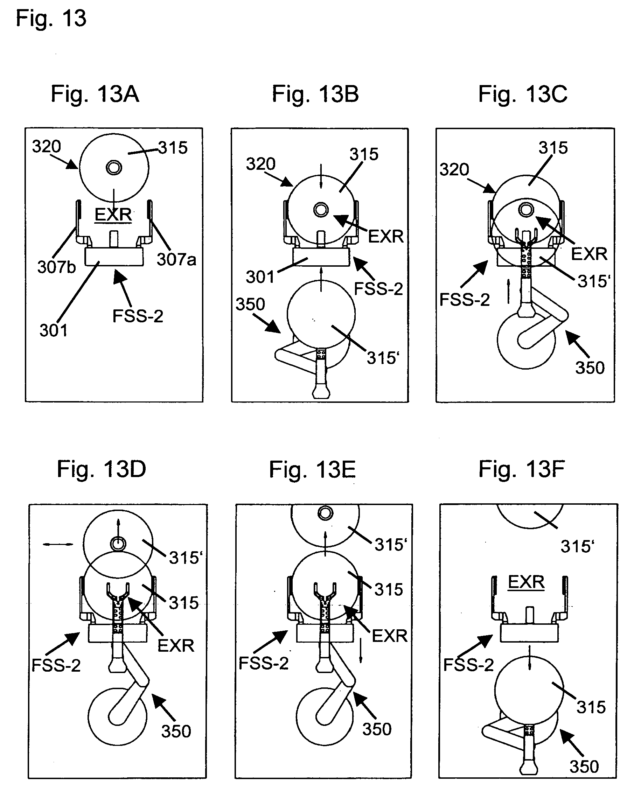

Es wird nun Bezug auf die Fig. 13 genommen. Fig. 13 zeigt den beschleunigten Handhabungsvorgang oder Übertrag eines Wafers gemäß der Erfindung von beispielsweise einer Wafer enthaltenden Kassette zu beispielsweise einer Inspektionsstation (beide nicht gezeigt). Bei diesem Vorgang wird ein Wafer, der gerade inspiziert wurde von einem Aufspannkopf eines x-y-Gestells in einen Austauschbereich EXR gebracht. Dort befindet sich eine der erfindungsgemäßen Wechselvorrichtungen FSS-1 oder FSS-2 und wartet auf das Eintreffen des Wafers 315 (Fig. 13A). Die Arme 307a und 307b der Wechselvorrichtung FSS-2 befinden sich in ihren jeweiligen unteren und offenen Position. Dies könnte funktionell zum Beispiel durch die Hubvorrichtung 202 und durch den Manipulatorantrieb 203 gemäß einer der beschriebenen Ausführungsformen erreicht werden. In Fig. 13B bewegt das x-y-Gestell mit dem Aufspannkopf 320 den Wafer 315 in die erfindungsgemäße Wechselstation FSS-2, d. h. zwischen die Arme von FSS-2. Die Wechselstation FSS-2 greift und hebt den Wafer an, d. h. lädt den Wafer von vorn von dem Aufspannkopf mittels des erfindungsgemäßen Antriebsmechanismus 301 und der Arme 307a und 307b. Nachdem sie gerade den Wafer von dem Aufspannkopf 320 aufgegriffen hat, wird ein neuer zu inspizierender Wafer 315' durch den Roboter 350 zu dem Austauschbereich EXR gebracht. Der Roboter platziert den neuen Wafer 315' auf dem Aufspannkopf 320 unter der Wechselstation FSS-2 (Fig. 13C). Dann zieht das x-y-Gestell den Aufspannkopf mit dem neuen Wafer 315' aus der Austauschstation EXR zu der Inspektionsstation (Fig. 13D). Danach oder parallel dazu greift dieser Roboter 350 den alten Wafer 315 von der erfindungsgemäßen Wechselstation FSS-2 auf und zieht seinen Arm mit dem alten Wafer 315 aus der erfindungsgemäßen Wechselstation FSS-2 heraus (Fig. 13E). Im folgenden werden der Aufspannkopf 320 und der Roboter 350 beide zurückgezogen, wobei der Roboter 350 den alten Wafer 315 hält und der Aufspannkopf den neuen Wafer 315' (Fig. 13F).

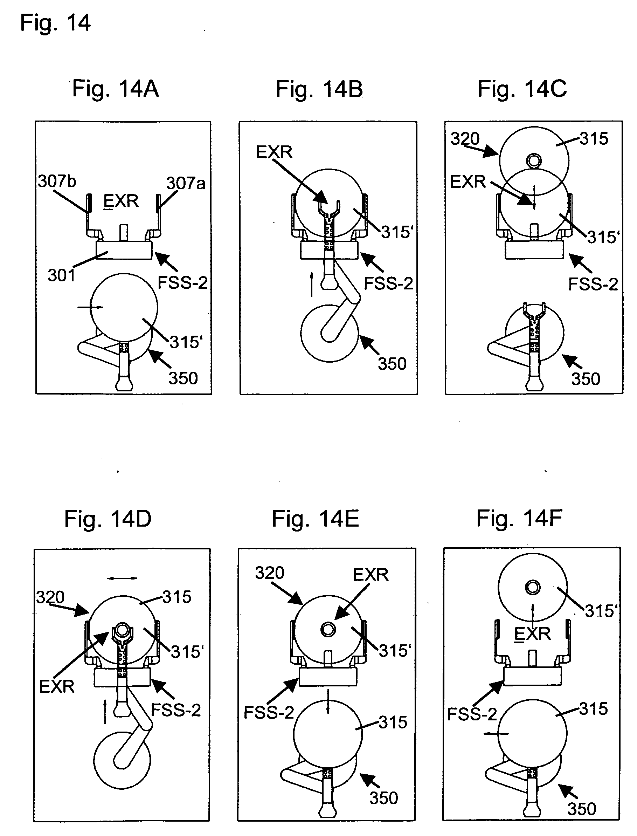

Die Figuren 14A bis 14F zeigen den gleichen Vorgang wie in den Figuren 13A bis 13F mit dem Unterschied, das die Wechselstation FSS-2 oder FSS-1 zuerst von hinten mit einem neuen Wafer 315' beladen wird und danach den neuen Wafer 315' auf dem Aufspannkopf freigibt. So zeigt das erste Bild 14A den zu der Austauschstation EXR kommenden Roboter 350, wobei die FSS-2 darauf wartet, den Wafer 315' anzunehmen. Nachdem er die Wechselposition erreicht hat, platziert der Roboter unter der FSS-2 den neuen Wafer auf der FSS-2, die sich mit ihren Armen in der oberen oder Halteposition befindet (Fig. 14B). Parallel dazu und/oder danach kommt das x-y-Gestell mit seinem Aufspannkopf in den Austauschbereich EXR oder die Austauschposition, in dem die Arme der FSS positioniert sind. Der Roboterhandhaber 350 zieht sich aus der Wechselstation FSS-2 zurück (Fig. 14C). Nachdem er an der Austauschposition angekommen ist, erhält der Roboter den alten Wafer 315 von dem Aufspannkopf des x-y-Gestells (Fig. 14D). Dann zieht der Roboter 350 seinen Arm mit dem alten Wafer 315 von dem Aufspannkopf 320 zurück, und die FSS-2 platziert den neuen Wafer 315' auf dem Aufspannkopf 320 des x-y-Gestells (Fig. 14E). Dann zieht das x-y-Gestell den Aufspannkopf 320 mit dem neuen Wafer 315' zurück und der Roboter 350 bringt den alten Wafer 315 beispielsweise zu einer Aufbewahrungskassette.

Obschon die bevorzugten Ausführungsformen der Erfindung beschrieben wurden, versteht es sich, dass die Erfindung zu anderen Anpassungen und Modifikationen innerhalb des Schutzumfangs der beigefügten Ansprüche in der Lage ist.

## Patentansprüche

1. Vorrichtung zum Wechseln zumindest eines scheibenartigen Elements (215), z. B. eines Wafers, wobei die Vorrichtung zumindest zwei zangenartige Arme (207a, 207b) zum Annehmen und Halten des scheibenartigen Elements (215) und einen Antriebsmechanismus (201) umfasst, der dafür ausgelegt ist, die Arme (207a, 207b) anzutreiben, wobei der Mechanismus (201) dafür ausgelegt ist, eine erste und zweite Bewegung der Arme (207a, 207b) bereitzustellen, **dadurch gekennzeichnet, dass**
der Antriebsmechanismus (201) eine Hubvorrichtung (202) und einen Manipulatorantrieb (203) umfasst, wobei mittels der Hubvorrichtung (202) die erste Bewegung eine vertikal ausgerichtete Bewegung der Arme (207a, 207b) von einer oberen in eine untere Position und umgekehrt umfasst und wobei die zweite Bewegung, welche durch den Manipulatorantrieb (203) bewirkt wird, eine horizontal ausgerichtete, zangenartige Bewegung der Arme (207a, 207b) umfasst,
wobei der Manipulatorantrieb (203) durch die Hubvorrichtung (202) in einer Richtung senkrecht zu einer Ebene anhebbar ist, die von der Bewegung der Arme (207a, 207b) definiert wird,
und wobei die Vorrichtung ein Gehäuse (227) umfasst, in dem zumindest ein Teil des Antriebmechanismus (201) für die zangenartige Arme (207a, 207b) untergebracht ist,
wobei das Gehäuse Öffnungen aufweist, durch die sich die Arme (207a, 207b) erstrecken, um das scheibenartige Element (215) zu ergreifen.

2. Vorrichtung nach Anspruch 1, wobei der Antriebsmechanismus (201) eine Hebelvorrichtung (234) und/oder ein Spindelmittel (216) zur Steuerung der Bewegung der Arme (207a, 207b) umfasst.

3. Vorrichtung nach einem der Ansprüche 1 oder 2,
wobei der Antriebsmechanismus (100, 201), wenn er seine horizontal ausgerichtete, zangenartige Bewegung ausführt, dafür ausgelegt ist, die Arme (107a, 107b, 207a, 207b) in zumindest eine Halte- und zumindest eine Freigabeposition und umgekehrt zu bewegen.

4. Vorrichtung nach einem der vorhergehenden Ansprüche, wobei der Antriebsmechanismus (100, 201) dafür ausgelegt ist, die Arme (107a, 107b, 207a, 207b) in zwei verschiedene Haltepositionen und zwei, den Haltepositionen entsprechende Freigabepositionen zu bewegen.

5. Vorrichtung nach Anspruch 1, wobei die Arme (207a, 207b) Verlängerungsglieder (209a, 209b) umfassen.

6. Vorrichtung nach einem der vorhergehenden Ansprüche, wobei die Arme (107a, 107b, 207a, 207b) Greifmittel zum Ergreifen der scheibenartigen Elemente (118, 215) umfassen.

7. Vorrichtung nach Anspruch 6, wobei das Greifmittel zumindest einen gerillten, kreisförmigen Ringabschnitt (119a, 119b) umfasst, der an den Radius oder Durchmesser oder Umfang des zu greifenden scheibenartigen Elements (118, 215) angepasst ist.

8. Vorrichtung nach einem der vorhergehenden Ansprüche, wobei die Vorrichtung ein Gehäuse (102, 227) umfasst, das zumindest einen Teil des Antriebsmechanismus (100, 201, 301) beinhaltet.

9. Vorrichtung nach einem der vorhergehenden Ansprüche, wobei die Arme (107a, 107b, 207a, 207b) und/oder Greifmechanismen eine zangenartige Struktur umfassen, die die Arme (107a, 107b, 207a, 207b) in die Lage versetzt, von vorn oder hinten beladen zu werden.

10. Vorrichtung nach einem der vorhergehenden Ansprüche, wobei der Antriebsmechanismus (100, 201, 301) zumindest einen Antriebsmotor umfasst.

11. Vorrichtung nach einem der vorhergehenden Ansprüche, wobei die Arme (107a, 107b, 207a, 207b) an dem Antriebsmechanismus befestigt sind.

12. Vorrichtung nach einem der vorhergehenden Ansprüche, wobei die Vorrichtung Sensormittel (226, 223a, 223b, 224a, 224b, 225a, 225b, 249) umfasst, um das scheibenartige Element (118, 215) zu erfassen und/oder um die Position der Arme (107a, 107b, 207a, 207b) zu erfassen.

13. Vorrichtung nach einem der vorhergehenden Ansprüche, wobei die Vorrichtung Steuermittel umfasst oder damit verbunden ist, um die Bewegung der Arme (107a, 107b, 207a, 207b) zu steuern.

14. Verfahren zur Handhabung oder zum Transport scheibenartiger Elemente, z. B. Wafern; mit folgenden Schritten:
a) Positionierung einer Vorrichtung nach einem der vorhergehenden Ansprüche in einem Austauschbereich zum Austauschen von scheibenartigen Elementen,
b) Transportieren eines ersten scheibenartigen Elements mit ersten Transportmitteln von einer ersten Position zu dem Austauschbereich,
c) Laden des ersten scheibenartigen Elements in die Vorrichtung,
d) Transportieren eines zweiten scheibenartigen Elements mit zweiten Transportmitteln zu dem Austauschbereich,
e) Laden des zweiten scheibenartigen Elements von dem zweiten Transportmittel auf das erste Transportmittel,
f) Übertragen des ersten scheibenartigen Elements aus der Vorrichtung zu dem zweiten Transportmittel,
g) Transportieren des zweiten scheibenartigen Elements mit dem zweiten Transportmittel zu einer zweiten Position.

15. Handhabungssystem zur Ausführung eines Verfahrens nach Anspruch 14 mit ersten und zweiten Transportmitteln und einer Vorrichtung nach einem der Ansprüche 1 bis 13.

16. Handhabungssystem nach Anspruch 15, wobei das erste Transportmittel oder das zweite Transportmittel entweder ein x-y-Gestell oder ein Aufspannkopf (120) oder ein Roboter (350) ist.

17. Vorrichtung zum Wechseln zumindest eines scheibenartigen Elements (118), z. B. eines Wafers, wobei die Vorrichtung zumindest zwei zangenartige Arme (107a, 107b) zum Annehmen und Halten des scheibenartigen Elements (118) und einen Antriebsmechanismus (100) umfasst, der dafür ausgelegt ist, die Arme (107a, 107b) anzutreiben, wobei der Mechanismus (100) dafür ausgelegt ist, eine erste und zweite Bewegung der Arme (107a, 107b) bereitzustellen, **dadurch gekennzeichnet, dass**
der Antriebsmechanismus (100) eine drehbare Steuerkurvenplatte (104) umfasst, die zwei höhere Ringe (104a, 104b) mit einer höhenveränderlichen Topographie aufweist, welche Steuerkurvenstrukturen (103a, 103b) auf der Steuerkurvenplatte (104) wiedergeben,
wobei beim Drehen der Steuerkurvenplatte (104) die Arme (107a, 107b) der Topographie der Steuerkurvenstruktur (103a, 103b) folgen, so dass
die erste Bewegung als eine vertikal ausgerichtete Bewegung der Arme (107a, 107b) von einer oberen in eine untere Position und umgekehrt ausführbar ist und die zweite Bewegung als eine horizontal ausgerichtete, zangenartige Bewegung der Arme (107a, 107b) ausführbar ist.

## Claims

1. Apparatus for swapping at least one disk-like member (215), e.g. a wafer, said apparatus comprising at least two tongs-like arms (207a, 207b) for accepting and holding the disk-like member (215) and a driving-mechanism (201) adapted to drive said arms (207a, 207b), wherein said mechanism (201) is adapted to provide a first and a second movement of said arms (207a, 207b),
**characterized in that**
the driving mechanism (201) comprises an elevation contrivance (202) and a manipulator drive (203), wherein, by using the elevation contrivance (202), the first movement comprises a vertically orientated movement of said arms (207a, 207b) from an up to a down position or vice versa, and wherein the second movement, which is done by said manipulator drive (203), comprises a horizontally oriented tongs-like movement of said arms (207a, 207b), wherein the manipulator drive (203) can be elevated by said elevation contrivance (202) in a direction perpendicular to a plan defined by the movement of said arms (207a, 207b),
and wherein the apparatus comprises a housing (227), in which at least a part of the driving mechanism (201) for the tongs-like arms (207a, 207b) is accommodated, wherein the housing comprises openings through which the arms (207a, 207b) extend for to grip the disk-like member (215).

2. Apparatus according to claim 1, wherein said driving mechanism (201) comprises a lever apparatus (234) and/or spindle means (216) for controlling said movement of said arms (207a, 207b).

3. Apparatus according to claims 1 to 2, wherein said driving mechanism (100, 201), when performing its horizontally oriented tongs-like movement, is adapted to move said arms (107a, 107b, 207a, 207b) into at least one hold and into at least one release position and vice versa.

4. Apparatus according to one of the preceding claims,
wherein said driving mechanism (100, 201) is adapted to move said arms (107a, 107b, 207a, 207b) into two different hold positions and into two release positions corresponding to said hold positions.

5. Apparatus according to claim 1, wherein said arms (207a, 207b) comprise extension members (209a, 209b).

6. Apparatus according to one of the preceding claims,
wherein said arms (107a, 107b, 207a, 207b) comprise gripping means for gripping said disk-like member (118, 215).

7. Apparatus according to claim 6, wherein said gripping means comprises at least one grooved circular ring (119a, 119b) section adapted to the radius or diameter or circumference of said disk-like member (118, 215) to be gripped.

8. Apparatus according to one of the preceding claims,
wherein said apparatus comprises a housing (102, 227) including at least a part of the driving mechanism (100, 201, 301).

9. Apparatus according to one of the preceding claims,
wherein said arms (107a, 107b, 207a, 207b) and/or gripping means comprise a tongs-like structure which enables the arms (107a, 107b, 207a, 207b) to be front- or to be back-loaded.

10. Apparatus according to one of the preceding claims,
wherein said driving mechanism (100, 201, 301) comprises at least one driving motor.

11. Apparatus according to one of the preceding claims,
wherein said arms (107a, 107b, 207a, 207b) are affixed to said driving mechanism.

12. Apparatus according to one of the preceding claims,
wherein the apparatus comprises sensor means (226, 223a, 223b, 224b, 225a, 225b, 249) for detecting said disk-like member (118, 215) and/or for detecting the position of said arms (107a, 107b, 207a, 207b).

13. Apparatus according to one of the preceding claims,
wherein the apparatus comprises or is connectable to control means for controlling said movement of said arms (107a, 107b, 207a, 207b).

14. Method for handling or transporting disk-like members, e.g. wafers, comprising the following steps:
a) Positioning an apparatus according to one of the preceding claims into an exchange-region for exchanging dislike-members,
b) transporting a first disk-like member with first transport means from a first position to the exchange region,
c) loading said first disk-like member into said apparatus
d) transporting a second disk-like member with second transport means to said exchange region,
e) loading said second disk-like member from said second transport means to said first transport means,
f) transferring said first disk-like member from said apparatus to said second transport means,
g) transporting said second disk-like member to a second position with said second transport means.

15. Handling system for carrying out a method according to claim 14 comprising first and second transport means, and an apparatus according to one of claims 1 to 13.

16. Handling system according to claim 15 wherein said first transport means or said second transport means is either a x-y-stage or chuck (120) or a robot (350).

17. Apparatus for swapping at least one disk-like member (118), e.g. a wafer, said apparatus comprising at least two tongs-like arms (107a, 107b) for accepting and holding the disk-like member (118) and a driving-mechanism (100) adapted to drive said arms (107a, 107b), wherein said mechanism (100) is adapted to provide a first and a second movement of said arms (107a, 107b),
**characterized in that**
said driving-mechanism (100) comprises a rotatable cam plate (104), which comprises two higher rings (104a, 104b) with a changing topography in height which reflects cam structures (103a, 103b) on a cam plate (104),
wherein, when rotating said cam plate (104), the arms (107a, 107b) follow the topography of said cam structure (103a, 103b), so that
said first movement is performable as a vertically oriented movement of said arms (107a, 107b) from an up to a down position and vice versa, and said second movement is performable as a horizontally oriented tongs-like movement of said arms (107a, 107b).

## Revendications

1. Dispositif permettant de changer au moins un élément de type disque (215), par exemple une tranche, le dispositif comprenant au moins deux bras (207a, 207b) de type pince servant à prendre et à retenir l'élément de type disque (215), et un mécanisme d'entraînement (201) qui est conçu pour entraîner les bras (207a, 207b), le mécanisme (201) étant conçu pour assurer un premier et un deuxième déplacement des bras (207a, 207b),
**caractérisé en ce que** :
le mécanisme d'entraînement (201) comprend un dispositif de levage (202) et un entraînement de manipulateur (203), le premier déplacement comportant un déplacement orienté verticalement des bras (207a, 207b) d'une position supérieure dans une position inférieure et inversement, au moyen du dispositif de levage (202), et le deuxième déplacement, lequel est provoqué par l'entraînement de manipulateur (203), comportant un déplacement de type pince, orienté horizontalement, des bras (207a, 207b),
l'entraînement de manipulateur (203) pouvant être soulevé par le dispositif de levage (202) dans une direction perpendiculaire à un plan qui est défini par le déplacement des bras (207a, 207b),
et le dispositif comprenant un boîtier (227) dans lequel est logée au moins une partie du mécanisme d'entraînement (201) pour les bras de type pince (207a, 207b),
le boîtier comprenant des orifices à travers lesquels les bras (207a, 207b) s'étendent, afin de saisir l'élément de type disque (215).

2. Dispositif selon la revendication 1, dans lequel le mécanisme d'entraînement (201) comprend un dispositif à levier (234) et/ou un moyen formant broche (216) servant à commander le déplacement des bras (207a, 207b).

3. Dispositif selon l'une quelconque des revendications 1 ou 2, dans lequel le mécanisme d'entraînement (100, 201), lorsqu'il réalise son déplacement de type pince orienté horizontalement, est conçu pour déplacer les bras (107a, 107b, 207a, 207b) dans au moins une position de retenue et au moins une position de libération et inversement.

4. Dispositif selon l'une quelconque des revendications précédentes, dans lequel le mécanisme d'entraînement (100, 201) est conçu pour déplacer les bras (107a, 107b, 207a, 207b) dans deux différentes positions de retenue et deux positions de libération correspondant aux positions de retenue.

5. Dispositif selon la revendication 1, dans lequel les bras (207a, 207b) comprennent des éléments de rallonge (209a, 209b).

6. Dispositif selon l'une quelconque des revendications précédentes, dans lequel les bras (107a, 107b, 207a, 207b) comprennent un moyen de préhension servant à saisir les éléments de type disque (118, 215).

7. Dispositif selon la revendication 6, dans lequel le moyen de préhension comprend au moins une section annulaire (119a, 119b) circulaire rainurée, qui est adaptée au rayon ou au diamètre ou à la circonférence de l'élément de type disque (118, 215) à saisir.

8. Dispositif selon l'une quelconque des revendications précédentes, le dispositif comprenant un boîtier (102, 227) qui contient au moins une partie du mécanisme d'entraînement (100, 201, 301).

9. Dispositif selon l'une quelconque des revendications précédentes, dans lequel les bras (107a, 107b, 207a, 207b) et/ou les mécanismes de préhension comportent une structure de type pince, qui permet aux bras (107a, 107b, 207a, 207b) d'être chargés depuis l'avant ou l'arrière.

10. Dispositif selon l'une quelconque des revendications précédentes, dans lequel le mécanisme d'entraînement (100, 201, 301) comprend au moins un moteur d'entraînement.

11. Dispositif selon l'une quelconque des revendications précédentes, dans lequel les bras (107a, 107b, 207a, 207b) sont fixés sur le mécanisme d'entraînement.

12. Dispositif selon l'une quelconque des revendications précédentes, le dispositif comprenant des moyens de détection (226, 223a, 223b, 224a, 224b, 225a, 225b, 249), afin de détecter l'élément de type disque (118, 215) et/ou afin de détecter la position des bras (107a, 107b, 207a, 207b).

13. Dispositif selon l'une quelconque des revendications précédentes, le dispositif comprenant des moyens de commande ou étant relié à ces derniers, afin de commander le déplacement des bras (107a, 107b, 207a, 207b).

14. Procédé de manipulation ou de transport d'éléments de type disque, par exemple de tranches, comprenant les étapes suivantes :
a) le positionnement d'un dispositif selon l'une quelconque des revendications précédentes dans une zone d'échange servant à échanger des éléments de type disque,
b) le transport d'un premier élément de type disque à l'aide de premiers moyens de transport d'une première position vers la zone d'échange,
c) le chargement du premier élément de type disque dans le dispositif,
d) le transport d'un deuxième élément de type disque à l'aide de deuxièmes moyens de transport vers la zone d'échange,
e) le chargement du deuxième élément de type disque du deuxième moyen de transport sur le premier moyen de transport,
f) le transfert du premier élément de type disque du dispositif vers le deuxième moyen de transport,
g) le transport du deuxième élément de type disque à l'aide du deuxième moyen de transport vers une deuxième position.

15. Système de manipulation permettant de mettre en oeuvre un procédé selon la revendication 14, comprenant des premiers et deuxièmes moyens de transport et un dispositif selon l'une quelconque des revendications 1 à 13.

16. Système de manipulation selon la revendication 15, le premier moyen de transport ou le deuxième moyen de transport étant soit un châssis x-y, soit une tête de serrage (120), soit un robot (350).

17. Dispositif permettant de changer au moins un élément de type disque (118), par exemple une tranche, le dispositif comprenant au moins deux bras (107a, 107b) de type pince servant à prendre et à retenir l'élément de type disque (118), et un mécanisme d'entraînement (100) qui est conçu pour entraîner les bras (107a, 107b), le mécanisme (100) étant conçu pour assurer un premier et un deuxième déplacement des bras (107a, 107b),
**caractérisé en ce que** :
le mécanisme d'entraînement (100) comprend une plaque à came de commande (104) rotative, qui comprend deux bagues supérieures (104a, 104b) présentant une topographie variable en hauteur, lesquelles reproduisent des structures de came de commande (103a, 103b) sur la plaque à came de commande (104),
les bras (107a, 107b) suivant la topographie de la structure de came de commande (103a, 103b) lors de la rotation de la plaque à came de commande (104), de sorte que :
le premier déplacement peut être réalisé sous la forme d'un déplacement, orienté verticalement, des bras (107a, 107b) d'une position supérieure dans une position inférieure et inversement, et le deuxième déplacement peut être réalisé sous la forme d'un déplacement de type pince, orienté horizontalement, des bras (107a, 107b).
